# EUROPÄISCHE PATENTSCHRIFT

(11) **EP 3 176 884 B1**
(45) Veröffentlichungstag und Bekanntmachung des Hinweises auf die Patenterteilung: **29.05.2019**
(21) Anmeldenummer: 16188913.4
(22) Anmeldetag: 15.09.2016
(51) Int. Cl.: H01R 13/66

(54) **STROMVERSORGUNGSKABEL MIT INTEGRIERTER GLEICHTAKTDROSSEL**
POWER SUPPLY CABLES WITH INTEGRATED COMMON MODE CHOKE
CÂBLE D'ALIMENTATION ÉLECTRIQUE COMPRENANT UN SELF DE MODE COMMUN

(30) Priorität: 30.11.2015 PT 15108993
(43) Veröffentlichungstag der Anmeldung: 07.06.2017
(73) Patentinhaber: Bosch Termotecnologia S.A., 3800-533 Aveiro (PT)
(72) Erfinder: Oliveira, Jose, 3850-577 Branca (PT); Quinteiro, Vasco Bastos Malva, 3810-056 Aveiro (PT)
(74) Vertreter: Bee, Joachim

(56) Entgegenhaltungen:
- DE-A1-102006 012 518
- DE-U1-202014 005 631
- US-A1- 2013 162 370

## Beschreibung

### Stand der Technik

Es ist bereits ein Stromversorgungskabel mit zumindest zwei Adern, welche in zumindest einem Normalbetriebszustand zu einer Stromführung vorgesehen sind, vorgeschlagen worden.

### Offenbarung der Erfindung

Die Erfindung geht aus von einem Stromversorgungskabel mit zumindest zwei Adern, welche in zumindest einem Normalbetriebszustand zu einer Stromführung vorgesehen sind.

Es wird vorgeschlagen, dass das Stromversorgungskabel zumindest eine integrierte Gleichtaktdrossel aufweist. Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt. Bei den Adern handelt es sich insbesondere um Außenleiter und/oder Neutralleiter. Insbesondere kann das Stromversorgungskabel eine größere Anzahl von Adern, insbesondere eine größere Anzahl von Außenleitern, aufweisen.

Unter einer "Gleichtaktdrossel" soll insbesondere eine Drossel verstanden werden, welche eine Mehrzahl gleicher Wicklungen aufweist, welche dazu vorgesehen sind, gegensinnig von einem Arbeitsstrom durchflossen zu werden, sodass sich deren magnetische Felder im Kern der Drossel aufheben. Die Gleichtaktdrossel weist insbesondere einen einteiligen, geschlossenen Ferritkern in Ringform, E-Form, Rahmenform oder sogenannter D-Form auf, wobei die Wicklungsdrähte bei Ringkernen hindurchgefädelt oder auf Spulenkörpern aufgewickelt sind. Ferner soll unter "integriert" insbesondere verstanden werden, dass die Gleichtaktdrossel zumindest teilweise einstückig mit zumindest einer weiteren Komponente und/oder mit zumindest einem weiteren Element des Stromversorgungskabels ausgeführt ist. Unter "einstückig" soll insbesondere zumindest stoffschlüssig verbunden verstanden werden, beispielsweise durch einen Schweißprozess, einen Lötprozess, einen Klebeprozess, einen Anspritzprozess und/oder einen anderen, dem Fachmann als sinnvoll erscheinenden Prozess. Vorzugsweise sind die Adern jeweils elektrisch leitend mit jeweils einer Wicklung der Gleichtaktdrossel verbunden.

Durch eine derartige Ausgestaltung kann ein gattungsgemäßes Stromversorgungskabel mit vorteilhaften Eigenschaften hinsichtlich einer EMV-Entstörung von Elektrogeräten bereitgestellt werden. Insbesondere kann das Stromversorgungskabel vorteilhaft einfach zu einer Stromversorgung und Entstörung von Elektrogeräten verwendet werden, welche nicht den EMV-Richtlinien entsprechen.

Solche Stromversorgungskabel sind beispielsweise aus DE 20 2014 005 631 U1 und US 2013/0162370 bekannt.

Es wird erfindungsgemäß vorgeschlagen, dass das Stromversorgungskabel zumindest eine weitere Ader aufweist, welche im Normalbetriebszustand zumindest im Wesentlichen stromlos und in zumindest einem Fehlerbetriebszustand zu einer zumindest zeitweisen Stromführung vorgesehen ist. Dabei ist die weitere Ader elektrisch von der Gleichtaktdrossel getrennt angeordnet. Insbesondere kann die weitere Ader als ein Schutzleiter ausgebildet sein. Hierdurch kann vorteilhaft ein Stromversorgungskabel für die Verwendung mit Elektrogeräten, welche einen Schutzleiter vorsehen, bereitgestellt werden.

Ferner wird vorgeschlagen, dass das Stromversorgungskabel zumindest ein Gehäuse, insbesondere ein Kunststoffgehäuse aufweist, welches die Gleichtaktdrossel zumindest im Wesentlichen vollständig umschließt. Vorzugsweise ist das Gehäuse als ein Umspritzgehäuse ausgebildet. Hierdurch können ein vorteilhafter mechanischer Schutz und/oder eine vorteilhafte elektrische Isolierung der Gleichtaktdrossel erreicht werden.

Zudem wird ein Elektrogerät mit einem Stromversorgungskabel, welches zumindest zwei Adern, die in zumindest einem Normalbetriebszustand zu einer Stromführung vorgesehen sind, und zumindest einer integrierte Gleichtaktdrossel aufweist, vorgeschlagen. Hierdurch kann eine vorteilhaft einfache und/oder kostengünstige Entstörung des Elektrogeräts erreicht werden.

Des Weiteren wird eine Heizvorrichtung, insbesondere ein Warmwasserspeicher, mit zumindest einem Elektrogerät vorgeschlagen, welches ein Stromversorgungskabel mit zumindest zwei Adern, die in zumindest einem Normalbetriebszustand zu einer Stromführung vorgesehen sind, und mit zumindest einer integrierte Gleichtaktdrossel aufweist. Vorzugsweise ist das Elektrogerät als eine Zirkulationspumpe ausgebildet. Unter einer Heizvorrichtung soll in diesem Zusammenhang insbesondere eine fest installierte Vorrichtung zur Erzeugung und/ oder zumindest temporären Speicherung von Warmwasser verstanden werden. Hierdurch kann eine vorteilhaft einfache und/oder kostengünstige Entstörung der Heizgerätevorrichtung erreicht werden

Ferner wird ein Verfahren zur Entstörung eines Elektrogeräts, insbesondere einer Zirkulationspumpe vorgeschlagen, wobei das Elektrogerät mittels einer in einem Stromversorgungskabel integrierten Gleichtaktdrossel entstört wird. Insbesondere kann das Stromversorgungskabel vorteilhaft einfach zu einer Stromversorgung und Entstörung von Elektrogeräten verwendet werden, welche nicht den EMV-Richtlinien entsprechen.

Das erfindungsgemäße Stromversorgungskabel soll hierbei nicht auf die oben beschriebene Anwendung und Ausführungsform beschränkt sein. Insbesondere kann das erfindungsgemäße Stromversorgungskabel zu einer Erfüllung einer hierin beschriebenen Funktionsweise eine von einer hierin genannten Anzahl von einzelnen Elementen, Bauteilen und Einheiten abweichende Anzahl aufweisen.

### Zeichnung

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Stromversorgungskabel mit integrierter Gleichtaktdrossel und,
- Fig. 2: ein vereinfachtes Blockschaltbild eines elektrischen Systems, welches ein Elektrogerät mit einem Stromversorgungskabel gemäß Figur 1 umfasst.

### Beschreibung des Ausführungsbeispiels

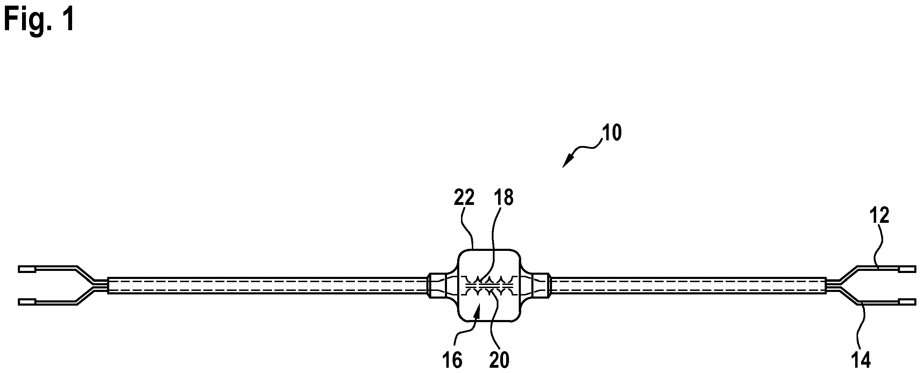

Figur 1 zeigt ein Stromversorgungskabel 10 mit zwei Adern 12, 14, welche in zumindest einem Normalbetriebszustand zu einer Stromführung vorgesehen sind. Das Stromversorgungskabel 10 weist eine integrierte Gleichtaktdrossel 16 auf. Die Gleichtaktdrossel 16 ist dazu vorgesehen, auftretende Gleichtaktstörungen zumindest zu vermindern. Die Adern 12, 14 sind jeweils elektrisch leitend mit jeweils einer Wicklung 18, 20 der Gleichtaktdrossel 16 verbunden.

Zusätzlich weist das Stromversorgungskabel 10 eine hier nicht gezeigte weitere Ader auf welche im Normalbetriebszustand zumindest im Wesentlichen stromlos und in zumindest einem Fehlerbetriebszustand zu einer zumindest zeitweisen Stromführung vorgesehen ist. Insbesondere kann die weitere Ader als ein Schutzleiter ausgebildet sein. Die weitere Ader ist elektrisch von der Gleichtaktdrossel 16 getrennt angeordnet.

Das Stromversorgungskabel 10 weist ein Gehäuse 22 auf, welches die Gleichtaktdrossel 16 vollständig umschließt. Das Gehäuse 22 ist zu einem mechanischen Schutz und zu einer elektrischen Isolierung der Gleichtaktdrossel 16 vorgesehen. Vorzugsweise ist das Gehäuse 22 als ein Umspritzgehäuse ausgebildet.

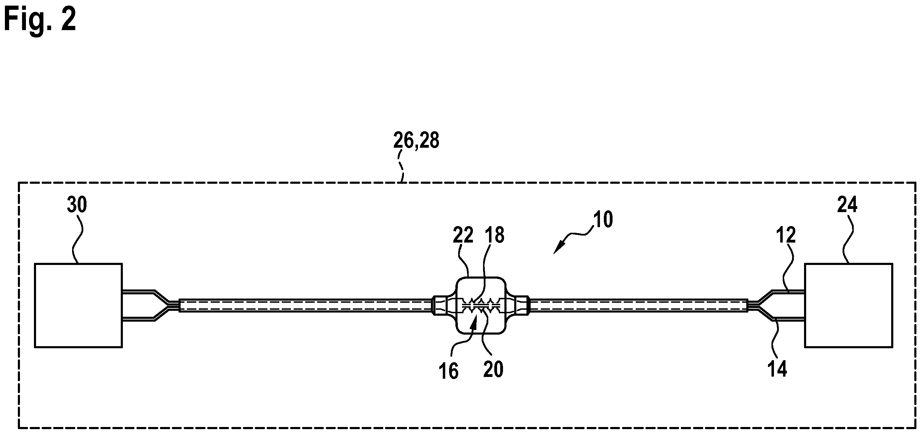

Figur 2 zeigt ein vereinfachtes Blockschaltbild eines elektrischen Systems 28. Das elektrische System 28 umfasst ein Elektrogerät 24 mit einem Stromversorgungskabel 10 gemäß Figur 1. Das Stromversorgungskabel 10 ist dazu vorgesehen, dem Elektrogerät 24 elektrische Energie zuzuführen.

Das elektrische System 28 ist beispielsweise als eine Heizvorrichtung 26, insbesondere als ein Warmwasserspeicher, ausgebildet. Das Elektrogerät 24 ist beispielsweise als eine Zirkulationspumpe ausgebildet. Die Heizvorrichtung 26 weist ferner ein Steuergerät 30 auf, welches dazu vorgesehen ist, eine Stromversorgung des Elektrogeräts 24 bereitzustellen. Das Elektrogerät 24 ist mittels des Stromversorgungskabels 10 mit dem Steuergerät 30 verbunden.

## Patentansprüche

1. Stromversorgungskabel mit zumindest zwei Adern (12, 14), welche in zumindest einem Normalbetriebszustand zu einer Stromführung vorgesehen sind, mit zumindest einer integrierten Gleichtaktdrossel (16) und mit zumindest einer weiteren Ader, **dadurch gekennzeichnet, dass** die weitere Ader im Normalbetriebszustand zumindest im Wesentlichen stromlos und in zumindest einem Fehlerbetriebszustand zu einer zumindest zeitweisen Stromführung vorgesehen und elektrisch von der Gleichtaktdrossel (16) getrennt angeordnet ist.

2. Stromversorgungskabel nach Anspruch 1, **dadurch gekennzeichnet, dass** die Adern (12, 14) jeweils elektrisch leitend mit jeweils einer Wicklung (18, 20) der Gleichtaktdrossel (16) verbunden sind.

3. Stromversorgungskabel nach Anspruch 1 oder 2, **gekennzeichnet durch** zumindest ein Gehäuse (22), welches die Gleichtaktdrossel (16) zumindest im Wesentlichen vollständig umschließt.

4. Stromversorgungskabel nach Anspruch 3, **dadurch gekennzeichnet, dass** das Gehäuse (22) als ein Umspritzgehäuse ausgebildet ist.

5. Elektrogerät mit einem Stromversorgungskabel (10) nach einem der vorhergehenden Ansprüche.

6. Heizvorrichtung, insbesondere Warmwasserspeicher, mit zumindest einem Elektrogerät (24) nach Anspruch 5.

7. Heizvorrichtung nach Anspruch 6, **dadurch gekennzeichnet, dass** das Elektrogerät (24) als eine Zirkulationspumpe ausgebildet ist.

8. Verfahren zur Entstörung eines Elektrogeräts (24), insbesondere einer Zirkulationspumpe, **dadurch gekennzeichnet dass** das Elektrogerät (24) mittels einer in einem Stromversorgungskabel (10) nach den Ansprüchen 1 - 4 integrierten Gleichtaktdrossel (16) entstört wird.

## Claims

1. Power supply cable having at least two wires (12, 14), which are provided to carry power in at least one normal operating state, having at least one integrated common mode choke (16) and having at least one further wire,
**characterized in that** in the normal operating state the further wire is at least substantially power-free and, in at least one faulty operating state, is provided to carry power at least temporarily, and is arranged electrically separately from the common mode choke (16).

2. Power supply cable according to Claim 1,
**characterized in that** the wires (12, 14) are each electrically conductively connected to a respective winding (18, 20) of the common mode choke (16).

3. Power supply cable according to Claim 1 or 2,
**characterized by** at least one housing (22), which at least substantially completely encloses the common mode choke (16).

4. Power supply cable according to Claim 3,
**characterized in that** the housing (22) is formed as an over-moulded housing.

5. Electrical appliance having a power supply cable (10) according to one of the preceding claims.

6. Heating device, in particular hot water tank, having at least one electrical appliance (24) according to Claim 5.

7. Heating device according to Claim 6, **characterized in that** the electrical appliance (24) is formed as a circulation pump.

8. Method for interference suppression of an electrical appliance (24), in particular a circulation pump, **characterized in that** the electrical appliance (24) has interference suppressed by means of a common mode choke (16) integrated in a power supply cable (10) according to Claims 1 - 4.

## Revendications

1. Câble d'alimentation électrique comprenant au moins deux fils (12, 14), lesquels sont conçus pour un acheminement du courant au moins dans un état opérationnel normal, comprenant au moins une réactance en mode commun (16) intégrée et comprenant au moins un fil supplémentaire, **caractérisé en ce que** le fil supplémentaire est conçu au moins sensiblement hors tension dans l'état opérationnel normal et au moins temporairement conducteur de courant dans au moins un état opérationnel de défaut et il est disposé isolé électriquement de la réactance en mode commun (16).

2. Câble d'alimentation électrique selon la revendication 1, **caractérisé en ce que** les fils (12, 14) sont respectivement reliés électriquement à un enroulement (18, 20) de la réactance en mode commun (16).

3. Câble d'alimentation électrique selon la revendication 1 ou 2, **caractérisé par** au moins un boîtier (22) qui entoure au moins pour l'essentiel entièrement la réactance en mode commun (16).

4. Câble d'alimentation électrique selon la revendication 3, **caractérisé en ce que** le boîtier (22) est réalisé sous la forme d'un boîtier moulé par injection.

5. Appareil électrique comprenant un câble d'alimentation électrique (10) selon l'une des revendications précédentes.

6. Dispositif de chauffage, notamment accumulateur d'eau chaude, comprenant au moins un appareil électrique (24) selon la revendication 5.

7. Dispositif de chauffage selon la revendication 6, **caractérisé en ce que** l'appareil électrique (24) est réalisé sous la forme d'une pompe de circulation.

8. Procédé d'antiparasitage d'un appareil électrique (24), notamment d'une pompe de circulation, **caractérisé en ce que** l'appareil électrique (24) est antiparasité au moyen d'une réactance en mode commun (16) intégrée dans un câble d'alimentation électrique (10) selon l'une des revendications 1 à 4.
